# EUROPEAN PATENT APPLICATION

(11) **EP 3 587 081 A1**
(43) Date of publication of application: **01.01.2020**
(21) Application number: 19176497.6
(22) Date of filing: 24.05.2019
(51) Int. Cl.: B29C 64/393, B29C 64/106, B33Y 10/00, B33Y 50/02, B29C 64/112, G05B 19/4099, G06F 17/50

(54) **SHAPING METHOD**

(30) Priority: 26.06.2018 JP 2018120606
(71) Applicant: Mimaki Engineering Co., Ltd., Tomi-city Nagano 389-0512 (JP)
(72) Inventor: HAKKAKU, Kunio, Tomi-city,, Nagano (JP); OHI, Hiroyoshi, Tomi-city, Nagano (JP)
(74) Representative: Bandpay & Greuter

(57) **Abstract**

A shaped object includes a colored region and a light reflecting region. In shape data on the shaped object provided in its surface with a recess, first and second polygons adjacent to each other are connected to each other in a recessed manner. When a region of the shaped object corresponding to a region formed by translating the first polygon by a thickness of the colored region in its normal direction is indicated as a first extension region, and a region of the shaped object corresponding to a region formed by translating the second polygon by the thickness of the colored region in its normal direction is indicated as a second extension region to be colored, a connection region between the first and second extension regions in the colored region is formed of a transparent material, or a material identical to a light reflective material constituting the light reflecting region, in the shaping method.

## Description

### TECHNICAL FIELD

The present disclosure relates to a shaping method for a three-dimensional shaped object.

### DESCRIPTION OF THE BACKGROUND ART

Conventionally, a shaping apparatus for shaping a three-dimensional shaped object is known (e.g., refer to Japanese Unexamined Patent Publication No. 2018-39126). Japanese Unexamined Patent Publication No. 2018-39126 discloses a shaping apparatus including an ejection head that ejects a modeling material with an inkjet method. The shaping apparatus shapes a shaped object that includes a colored region constituting a surface of the shaped object, and an inner region covered with the colored region. Shape data on an outer shape serving as shaping data of the shaped object shaped by the shaping apparatus is expressed as a surface set of triangular polygons (meshes), for example. The shaping apparatus forms a triangular prism by translating the shape of the polygon by a predetermined thickness inside the shaped object along the normal direction of the polygon in the shaping data of the shaped object, and a portion of the triangular prism on a surface side of the shaped object constitutes a part of the colored region.

For example, as illustrated in FIG. 9, the shaping apparatus disclosed in Japanese Unexamined Patent Publication No. 2018-39126 forms a triangular prism T1 by translating the shape of a polygon PG101 by a predetermined thickness inside a shaped object along the normal direction of the polygon PG101 in the shape data on the outer shape serving as the shaping data of the shaped object, a triangular prism T2 by translating the shape of a polygon PG102 by a predetermined thickness inside the shaped object along the normal direction of the polygon PG102 therein, and a triangular prism T3 by translating the shape of a polygon PG103 by a predetermined thickness inside the shaped object along the normal direction of the polygon PG103 therein. The portion of each of the triangular prisms T1 to T3 on the surface side of the shaped object constitutes a part of the colored region.

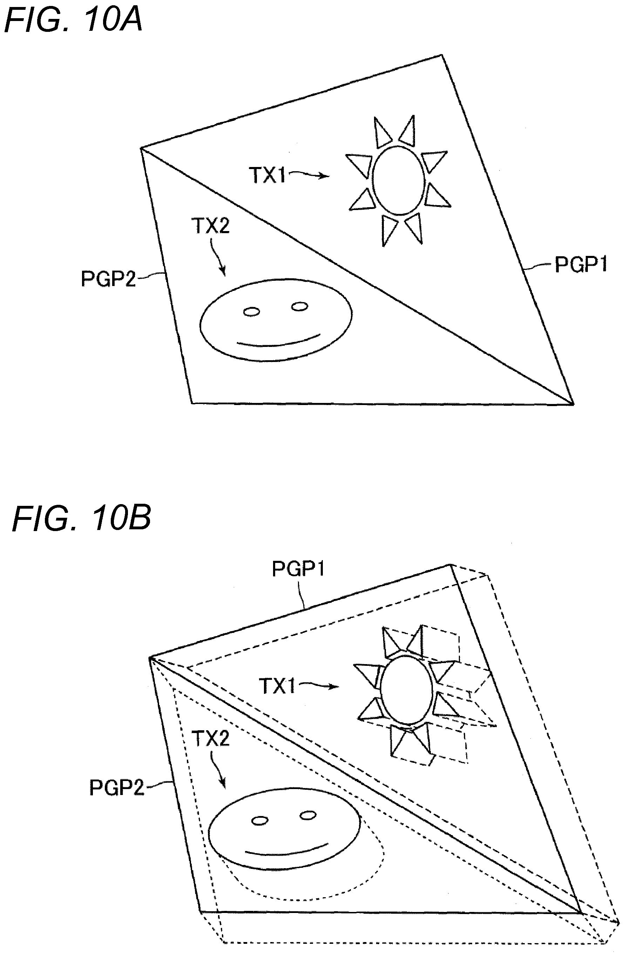

As illustrated in FIG. 10A, data (texture data) on textures (color, density, pattern, image, characters, etc.) TX1 and TX2 serving as coloring data on a shaped object are two-dimensional plane data with no thickness on polygon surfaces PGP1 and PGP2, respectively, and as illustrated in FIG. 10B, the texture data is extended with a thickness in the normal direction of each of the polygon surfaces PGP1 and PGP2, i.e., inside the triangular prism.

### SUMMARY

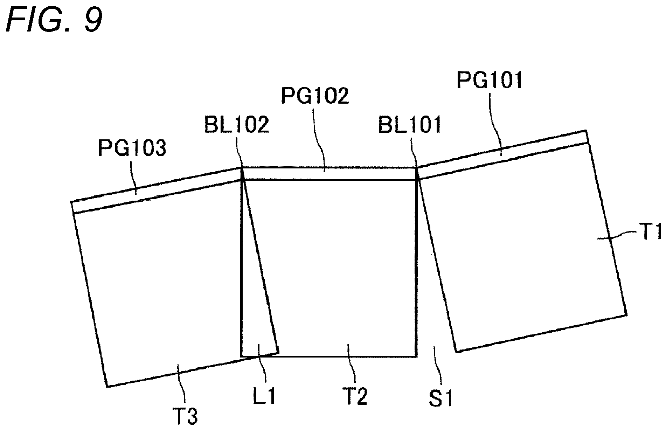

The shaping apparatus disclosed in Japanese Unexamined Patent Publication No. 2018-39126 shapes a shaped object having a surface provided with irregularities. When irregularities are formed on the surface of the shaped object, as illustrated in FIG. 9, the polygon PG101 and the polygon PG102 adjacent to each other are connected with a boundary line BL101 therebetween in a recessed manner on a surface side of the shaped object (i.e., connected to be recessed inward) in the shaping data on the shaped object, and the polygon PG102 and the polygon PG103 adjacent to each other are connected with a boundary line BL102 therebetween in a protruding manner on the surface side of the shaped object (i.e., connected to be pointed outside) therein.

When the polygon PG101 and the polygon PG102 are connected in a recessed manner on the surface side of the shaped object, a gap portion S1 is formed between the triangular prism T1 and the triangular prism T2 in the shaping data on the shaped object. To shape the shaped object, it is necessary to fill a portion corresponding to the gap portion S1 with a predetermined material. However, it has become clear by examination of the inventors of the present application that when the portion corresponding to the gap portion S1 is not filled by an appropriate method, a surface shape of the shaped object may be deformed, or texture of a portion corresponding to the boundary between the polygon PG101 and the polygon PG102 (i.e., the portion provided with a recess in the surface of the shaped object) may be discontinuous to impair an aesthetic appearance of the shaped object.

When the polygon PG102 and the polygon PG103 are connected in a protruding manner on the surface side of the shaped object, an overlapping portion L1 in which a part of the triangular prism T2 and a part of the triangular prism T3 overlap with each other is formed in the shaping data on the shaped object. However, it has become clear by examination of the inventors of the present application that when a portion corresponding to the overlapping portion L1 is not formed by an appropriate material, texture of a portion on the shaped object corresponding to the boundary between the polygon PG102 and the polygon PG103 (i.e., the portion provided with a protrusion in the surface of the shaped object) may be discontinuous to impair an aesthetic appearance of the shaped object.

Thus, it is a first problem of the present disclosure to provide a shaping method for a shaped object, being capable of maintaining an aesthetic appearance of the shaped object by preventing a surface of a portion provided with a recess from being deformed and texture of the portion from being discontinuous even when the recess is formed in a surface of a three-dimensional shaped object having a colored region with a predetermined thickness on the surface. In addition, it is a second problem of the present disclosure to provide a shaping method for a shaped object, being capable of maintaining an aesthetic appearance of the shaped object by preventing texture of a portion provided with a protrusion from being discontinuous even when the protrusion is formed in the surface of the three-dimensional shaped object having the colored region with the predetermined thickness on the surface.

To achieve the first problem described above, a shaping method of the present disclosure is a shaping method for shaping a three-dimensional shaped object, the shaped object including: a colored region that is at least partially colored; and a light reflecting region that is disposed inward of the colored region in the shaped object to reflect light incident through the colored region, in the following states: a plurality of polygons being shape data on the shaped object includes two polygons adjacent to each other, being connected to each other with a boundary line therebetween in a recessed manner on a surface side of the shaped object; one of the two polygons is indicated as a first polygon, and the other thereof is indicated as a second polygon; a direction of a normal of the first polygon, toward inside the shaped object, is indicated as a first normal direction, and a direction of a normal of the second polygon, toward inside the shaped object, is indicated as a second normal direction; and a region of the shaped object corresponding to a region formed by translating a shape of the first polygon by a thickness of the colored region in the first normal direction in data is indicated as a first extension region, and a region of the shaped object corresponding to a region formed by translating a shape of the second polygon by the thickness of the colored region in the second normal direction in data is indicated as a second extension region, the shaping method including the steps of: allowing the first and second extension regions to be included in the colored region and to be each formed of at least a coloring material; and allowing a connection region between the first and second extension regions in the colored region to be formed of a transparent material, a material identical to a light reflecting material constituting the light reflecting region, a material identical to a material constituting an end portion of the first extension region on a connection region side, or of a material identical to a material constituting an end portion of the second extension region on a connection region side, or allowing a portion of the connection region on a first extension region side to be formed of a material identical to a material constituting an end portion of the first extension region on a connection region side, and a residual portion of the connection region to be formed a material identical to a material constituting an end portion of the second extension region on a connection region side, or allowing the connection region to be formed of a material containing the coloring material included in the end portion of the first extension region on the connection region side and the coloring material included in the end portion of the second extension region on the connection region side while reducing a concentration of the material constituting the connection region to less than a sum of a concentration of the material constituting the end portion of the first extension region on the connection region side and a concentration of the material constituting the end portion of the second extension region on the connection region side.

In the shaping method of the present disclosure, the connection region between the first and second extension regions in the colored region is formed of the transparent material, the material identical to the light reflective material constituting the light reflecting region, the material identical to the material constituting the end portion of the first extension region on the connection region side, or the material identical to the material constituting the end portion of the second extension region on the connection region side. Alternatively, in the present disclosure, the portion of the connection region on the first extension region side is formed of the material identical to the material constituting the end portion of the first extension region on the connection region side, and the residual portion of the connection region is formed of the material identical to the material constituting the end portion of the second extension region on the connection region side. Alternatively, in the present disclosure, the connection region is formed of the material containing the coloring material included in the end portion of the first extension region on the connection region side and the coloring material included in the end portion of the second extension region on the connection region side, while the concentration of the material constituting the connection region is reduced to less than the sum of the concentration of the material constituting the end portion of the first extension region on the connection region side and the concentration of the material constituting the end portion of the second extension region on the connection region side. Thus, shaping a shaped object with the shaping method of the present disclosure enables an aesthetic appearance of the shaped object to be maintained by preventing a surface of a portion provided with a recess from being deformed and texture of the portion from being discontinuous even when the recess is formed in a surface of the three-dimensional shaped object, having a colored region with a predetermined thickness on the surface.

In addition, to achieve the second object described above, a shaping method of the present disclosure is a shaping method for shaping a three-dimensional shaped object, the shaped object including: a colored region that is at least partially colored; and a light reflecting region that is disposed inward of the colored region in the shaped object to reflect light incident through the colored region, in the following states: a plurality of polygons included in a polygon model being shape data on the shaped object includes two polygons adjacent to each other, being connected to each other with a boundary line therebetween in a protruding manner on a surface side of the shaped object; one of the two polygons is indicated as a first polygon, and the other thereof is indicated as a second polygon; a direction of a normal of the first polygon, toward inside the shaped object, is indicated as a first normal direction, and a direction of a normal of the second polygon, toward inside the shaped object, is indicated as a second normal direction; and a region of the shaped object corresponding to a region formed by translating a shape of the first polygon by a thickness of the colored region in the first normal direction in data is indicated as a first extension region, and a region of the shaped object corresponding to a region formed by translating a shape of the second polygon by the thickness of the colored region in the second normal direction in data is indicated as a second extension region, the shaping method including the steps of: allowing the first and second extension regions to be included in the colored region and to be each formed of at least a coloring material; and allowing a portion of a connection region where the first and second extension regions overlap with each other, on a first extension region side, to be formed of a material identical to a material constituting the first extension region, and a residual portion of the connection region to be formed of a material identical to a material constituting the second extension region, or allowing the connection region to be formed of the material identical to the material constituting the first extension region or the material identical to the material constituting the second extension region, or allowing the connection region to be formed of a material containing the coloring material included in the first extension region and the coloring material included in the second extension region while reducing a concentration of the material constituting the connection region to less than a sum of a concentration of the material constituting the first extension region and a concentration of the material constituting the second extension region.

In the shaping method of the present disclosure, the portion of the connection region where the first and second extension regions overlap with each other, on the first extension region side, is formed of the material identical to the material constituting the first extension region, and the residual portion of the connection region is formed of the material identical to the material constituting the second extension region. Alternatively, in the present disclosure, the connection region is formed of the material identical to the material constituting the first extension region or the material identical to the material constituting the second extension region. Alternatively, in the present disclosure, the connection region is formed of the material containing the coloring material included in the first extension region and the coloring material included in the second extension region while the concentration of the material constituting the connection region is reduced to less than the sum of the concentration of the material constituting the first extension region and the concentration of the material constituting the second extension region. Thus, shaping a shaped object with the shaping method of the present disclosure enables an aesthetic appearance of the shaped object to be maintained by preventing texture of the portion provided with the protrusion from being discontinuous even when the protrusion is formed in a surface of the three-dimensional shaped object having a colored region with a predetermined thickness on the surface.

In the present disclosure, it is preferable to allow a half portion of the connection region on the first extension region side to be formed of the material identical to the material constituting the first extension region, and a half portion of the connection region on the second extension region side to be formed of the material identical to the material constituting the second extension region. According to the examination of the inventors of the present application, the configuration as described above causes the texture of the portion provided with the protrusion to be less likely to be discontinuous, and as a result, an aesthetic appearance of the shaped object can be effectively maintained.

In the present disclosure, a colored portion in the colored region is formed of a coloring material, for example, or formed of the coloring material and a transparent material. When the colored portion of the colored region is formed of the coloring material and the transparent material, a concentration of the colored portion of the colored region can be adjusted by adjusting a content ratio of the transparent material. In the present disclosure, the light reflecting material constituting the light reflecting region is a white material, for example. In the present disclosure, a portion inside the colored region of the shaped object is formed of the light reflecting material, for example.

In the present disclosure, assuming that a direction perpendicular to the surface of the shaped object is a normal direction, the colored region has a thickness constant in the normal direction, for example. This enables suppressing a color difference due to difference in position and angle of the surface of the shaped object. In the present disclosure, assuming that the direction perpendicular to the surface of the shaped object is the normal direction, the light reflecting region also has a thickness constant in the normal direction, for example. Even this case enables suppressing the color difference due to difference in position and angle of the surface of the shaped object. In the present disclosure, the shaped object is shaped by an inkjet method, for example.

As described above, shaping a shaped object with the shaping method of the present disclosure enables an aesthetic appearance of the shaped object to be maintained by preventing a surface of a portion provided with a recess from being deformed and texture of the portion from being discontinuous even when the recess is formed in a surface of the three-dimensional shaped object having a colored region with a predetermined thickness on the surface. In addition, shaping a shaped object with the shaping method of the present disclosure enables an aesthetic appearance of the shaped object to be maintained by preventing texture of the portion provided with the protrusion from being discontinuous even when the protrusion is formed in a surface of the three-dimensional shaped object having a colored region with a predetermined thickness on the surface.

### BRIEF DESCRIPTION OF THE DRAWINGS

FIG. 1 is a schematic view for illustrating a configuration of a shaping apparatus for shaping a shaped object with a shaping method according to an embodiment of the present disclosure.
FIG. 2 is a view for illustrating a configuration of a head unit illustrated in FIG. 1.
FIG. 3 is an example of a sectional view of a shaped object formed by the shaping method according to the embodiment of the present disclosure.
FIGs. 4A and 4B are enlarged views for illustrating structure of a portion G of FIG. 3.
FIGs. 5A and 5B are enlarged views for illustrating structure of a portion H of FIG. 3.
FIG. 6 is a view for illustrating shape data on the portion G of FIG. 3.
FIG. 7 is a view for illustrating shape data on the portion H of FIG. 3.
FIG. 8 is an example of a sectional view of a shaped object according to another embodiment of the present disclosure.
FIG. 9 is a view for illustrating a problem of a conventional art.
FIGs. 10A and 10B are views for illustrating the conventional art.

### DETAILED DESCRIPTION OF EMBODIMENTS

Hereinafter, embodiments of the present disclosure will be described with reference to the drawings.

### (Schematic configuration of shaping apparatus)

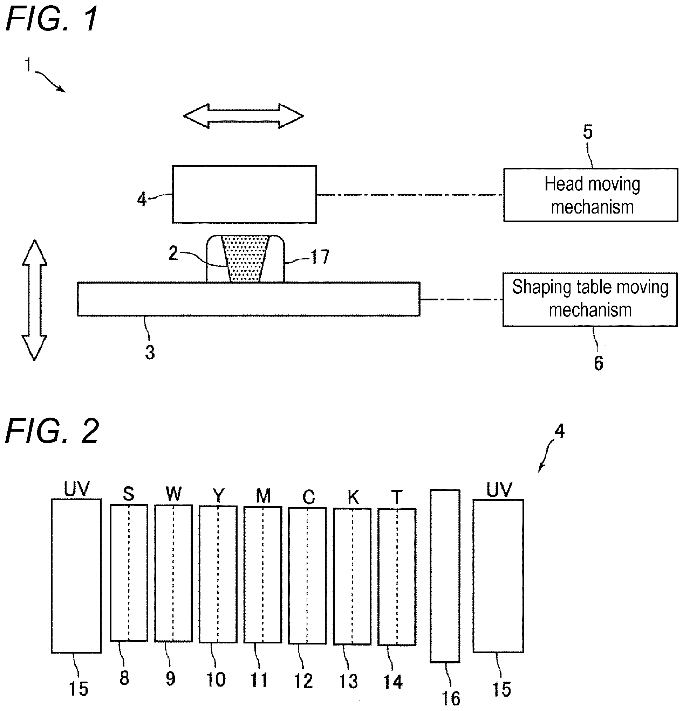

FIG. 1 is a schematic view for illustrating a configuration of a shaping apparatus 1 for shaping a shaped object 2 with a shaping method according to an embodiment of the present disclosure. FIG. 2 is a view for illustrating a configuration of a head unit 4 illustrated in FIG. 1.

In the present embodiment, the shaped object 2 is formed by the shaping apparatus 1. The shaping apparatus 1 is an inkjet printer, and the shaped object 2 is shaped by an inkjet method. The shaping apparatus 1 includes a shaping table 3 mounted with the shaped object 2 during shaping, a head unit 4 disposed above the shaping table 3, a head moving mechanism 5 for moving the head unit 4 in a main scanning direction, and a shaping table moving mechanism 6 for moving the shaping table 3 in a sub scanning direction and in a vertical direction.

The head unit 4 includes a plurality of inkjet heads 8 to 14 for ejecting ink droplets toward the shaping table 3. The head unit 4 of the present embodiment includes the seven inkjet heads 8 to 14, for example. The inkjet heads 8 to 14 eject ink droplets downward. The ink ejected from the inkjet heads 8 to 14 is an ultraviolet curable ink. The head unit 4 also includes two ultraviolet irradiators 15 that irradiate an ultraviolet-curable ink ejected from the inkjet heads 8 to 14 toward the shaping table 3 with ultraviolet rays to cure the ink, and a flattening roller 16 for flattening a surface of the ink ejected from the inkjet heads 8 to 14 toward the shaping table 3.

The inkjet head 8 ejects a support ink for supporting the shaped object 2. During shaping of the shaped object 2, a support material 17 supporting an overhanging portion of the shaped object 2 is formed around the shaped object 2 as needed (refer to FIG. 1). The support material 17 is formed of a support ink ejected from the inkjet head 8. The support material 17 is a water-soluble material, for example, and dissolved and removed by water when the shaping of the shaped object 2 is completed.

The inkjet head 9 ejects a white ink. The inkjet heads 10 to 13 each eject a color ink of a subtractive color mixture. In the present embodiment, the inkjet head 10 ejects a yellow ink, the inkjet head 11 ejects a magenta ink, the inkjet head 12 ejects a cyan ink, and the inkjet head 13 ejects a black ink. The inkjet head 14 ejects a transparent ink (clear ink).

The ultraviolet irradiator 15 is a UV LED. However, the ultraviolet irradiator 15 may be a metal halide lamp or a mercury lamp. The ultraviolet irradiator 15 emits ultraviolet light downward to cure all the inks including the support ink. The flattening roller 16 comes into contact with an upper surface of uncured ink ejected toward the shaping table 3 to remove excess ink, and flattens the upper surface of the ink. The shaping apparatus 1 shapes shaped object 2 by sequentially stacking ink layers, which are formed by ink ejected from the inkjet heads 8 to 14 and cured by ultraviolet rays irradiated from the ultraviolet irradiator 15, on an upper surface of the shaping table 3.

### (Structure of shaped object and shaping method for shaped object)

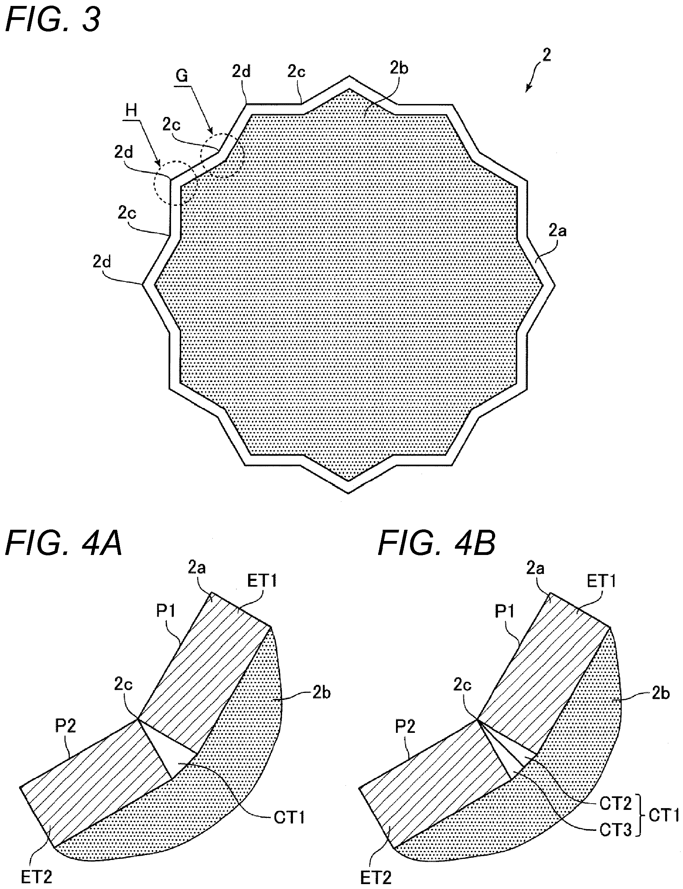

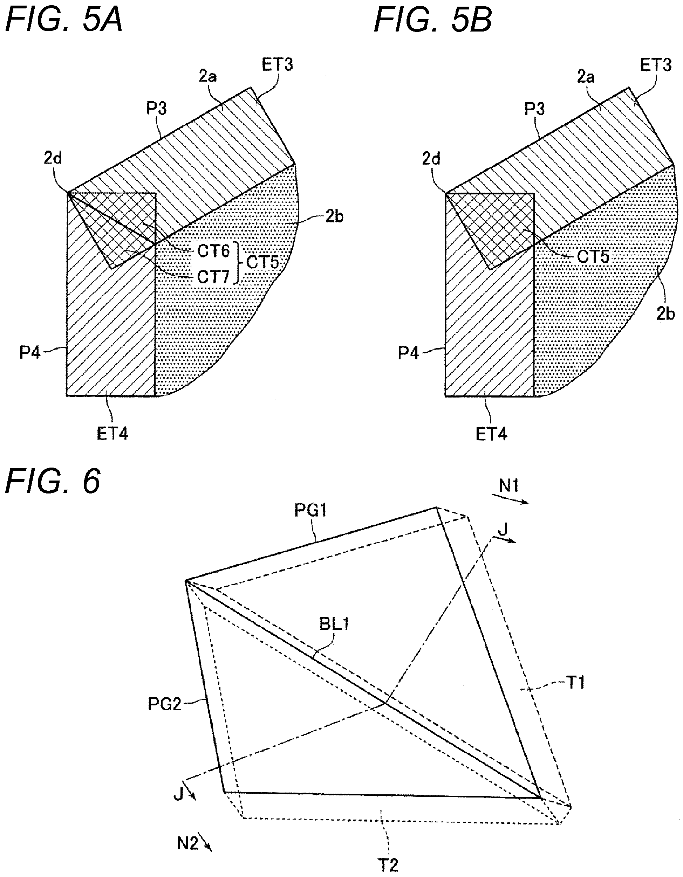

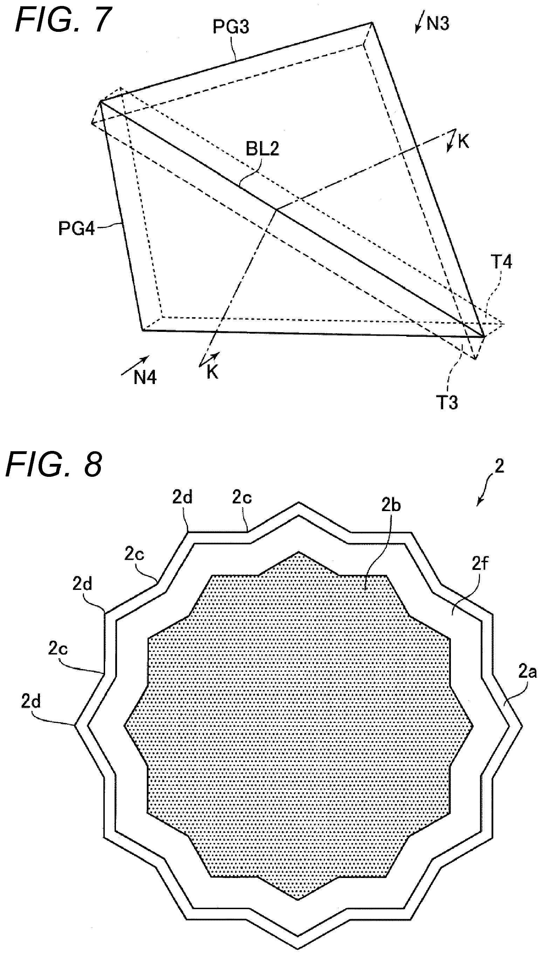

FIG. 3 is an example of a sectional view of the shaped object 2 formed by the shaping method according to the embodiment of the present disclosure. FIGs. 4A and 4B are enlarged views for illustrating structure of a portion G of FIG. 3. FIGs. 5A and 5B are enlarged views for illustrating structure of a portion H of FIG. 3. FIG. 6 is a view for illustrating shape data on the portion G of FIG. 3. FIG. 7 is a view for illustrating shape data on the portion H of FIG. 3.

The shaped object 2 includes a colored region 2a at least a part of which is colored, and a model region 2b covered with the colored region 2a. For example, the shaped object 2 includes the colored region 2a and the model region 2b, and the colored region 2a constitutes a surface of the shaped object 2. The surface of the shaped object 2 is provided with irregularities. That is, the surface of the shaped object 2 is provided with a recess 2c that is recessed toward inside the shaped object 2 and a protrusion 2d that is pointed toward outside the shaped object 2.

The colored portion in the colored region 2a is colored with a coloring material made of color ink ejected by the inkjet heads 10 to 13. The coloring material increases in amount when its density is high and decreases in amount when its density is low, so that the inkjet head 14 ejects a clear ink to the colored region 2a to prevent the colored region 2a from changing in thickness in the normal direction. Alternatively, the inkjet head 9 may eject a white ink to prevent the colored region 2a from changing in thickness.

Assuming that a direction perpendicular to the surface of the shaped object 2, i.e., the polygon surface, is the normal direction, the colored region 2a has a constant thickness in the normal direction. This enables suppressing a color difference due to difference in position and angle of the surface of the shaped object 2 in the present embodiment. The colored region 2a has a thickness of 50 (µm) to 500 (µm) in the normal direction, for example.

The model region 2b is formed of a white material made of a white ink ejected by the inkjet head 9. That is, the white material made of the white ink is the modeling material constituting the model region 2b. The model region 2b reflects light that passes through the colored region 2a and is incident into the model region 2b. That is, the white material constituting the model region 2b is a light reflecting material that reflects visible light, and that is an ink containing an inorganic pigment such as titanium oxide, for example.

The shaping apparatus 1 receives shape data of the shaped object 2 that is a polygon model (a polygon model representing the surface of the shaped object 2 as a set of many polygons) configured by combining a plurality of polygons. That is, the polygon model includes the plurality of polygons. Each of the polygons is a triangular plane, for example. Before shaping the shaped object 2, three-dimensional shape data of the shaped object 2 is sliced by a thickness of the ink layer to generate slice data. The shaping apparatus 1 receives texture data of the shaped object 2 that is typically color data (R, G, B) on an additive color mixture, and that includes a triangular surface having no thickness on the polygon surface. The triangular texture data is extended in the normal direction of the polygon to form a three-dimensional colored region 2a. Next, the texture data of the colored region 2a is sliced by the thickness of the ink layer simultaneously with the shape data to generate slice data. The sliced texture data is converted into color data (Y, M, C, K) on a subtractive color mixture from the color data on an additive color mixture, and then the inkjet heads 10 to 13 of the shaping apparatus 1 eject ink according to the color data. At the same time, a white ink, a clear ink, and a support ink are also ejected to the corresponding predetermined positions in the slice data.

As illustrated in FIG. 6, the shape data (polygon model) of the shaped object 2 includes a portion corresponding to the recess 2c at which the two polygons PG1 and PG2 adjacent to each other are connected to each other with the boundary line BL1 therebetween in a recessed manner on the surface side of the shaped object 2, and the polygons PG1 and PG2 form an angle of less than 180°. As illustrated in FIG. 7, the shape data (polygon model) of the shaped object 2 also includes a portion corresponding to the protrusion 2d at which the two polygons PG3 and PG4 adjacent to each other are connected to each other with the boundary line BL2 therebetween in a protruding manner on the surface side of the shaped object 2, and the polygons PG3 and PG4 form an angle of more than 180°. The polygons PG1 and PG3 in the present embodiment are each a first polygon, and the polygons PG2 and PG4 therein are each a second polygon.

In the following states: a direction of a normal of the polygon PG1, toward inside the shaped object 2, is indicated as a normal direction N1; a direction of a normal of the polygon PG2, toward inside the shaped object 2, is indicated as a normal direction N2; a region of the shaped object 2 corresponding to a region T1 formed by translating a shape of the polygon PG1 by a thickness of the colored region 2a (specifically, a thickness of the colored region 2a in the normal direction) in the normal direction N1 in data is indicated as an extension region ET1; and a region of the shaped object 2 corresponding to a region T2 formed by translating a shape of the polygon PG2 by the thickness of the colored region 2a in the normal direction N2 in data is indicated as an extension region ET2 (refer to FIGs. 4 and 6), the extension regions ET1 and ET2 are included in the colored region 2a.

The extension regions ET1 and ET2 are each formed of at least a coloring material. Specifically, the extension regions ET1 and ET2 are each formed of a coloring material made of color ink ejected by the inkjet heads 10 to 13, or the coloring material made of the color ink ejected by the inkjet heads 10 to 13 and a transparent material made of a clear ink ejected by the inkjet head 14. In the present embodiment, the extension regions ET1 and ET2 are different from each other in texture. However, the extension regions ET1 and ET2 each may have the same texture, or one image may be divided by the extension regions ET1 and ET2. The texture data includes a changing point in a surface direction that may or may not be correlated with the boundary line BL1 between the two adjacent polygons PG1 and PG2.

The normal direction N1 of the present embodiment is a first normal direction, and the normal direction N2 is a second normal direction. The extension region ET1 of the present embodiment is a first extension region, and the extension region ET2 is a second extension region. FIGs. 4A and 4B are sectional views of the shaped object 2, corresponding to a section taken along line J-J of FIG. 6. The shaped object 2 is provided in its surface with a plane P1 (refer to FIGs. 4A and 4B) corresponding to the polygon PG1, and a plane P2 (refer to FIGs. 4A and 4B) corresponding to the polygon PG2.

As illustrated in FIG. 4A, when a region in the colored region 2a, between the extension region ET1 and the extension region ET2 (i.e., a region surrounded by the extension region ET1, the extension region ET2, and the model region 2b) is indicated as a connection region CT1, the connection region CT1 is formed of a transparent material or a material identical to a modeling material (light reflective material) constituting the model region 2b in the shaping method of the present embodiment. That is, in the shaping method of the present embodiment, the connection region CT1 is formed of a transparent material made of a clear ink ejected by the inkjet head 14 or a white material made of a white ink ejected by the inkjet head 9. Alternatively, in the shaping method of the present embodiment, the connection region CT1 is formed of a material identical to a material constituting an end portion of the extension region ET1 on a connection region CT1 side, or a material identical to a material constituting an end portion of the extension region ET2 on a connection region CT1 side.

As described above, the shape data of the shaped object 2 includes the portion corresponding to the protrusion 2d at which the two polygons PG3 and PG4 adjacent to each other are connected to each other with the boundary line BL2 therebetween in a protruding manner. In the following states: a direction of a normal of the polygon PG3, toward inside the shaped object 2, is indicated as a normal direction N3; a direction of a normal of the polygon PG4, toward inside the shaped object 2, is indicated as a normal direction N4; a region of the shaped object 2 corresponding to a region T3 formed by translating a shape of the polygon PG3 by the thickness of the colored region 2a in the normal direction N3 in data is indicated as an extension region ET3; and a region of the shaped object 2 corresponding to a region T4 formed by translating a shape of the polygon PG4 by the thickness of the colored region 2a in the normal direction N4 in data is indicated as an extension region ET4 (refer to FIGs. 5 and 7), the extension regions ET3 and ET4 are included in the colored region 2a.

The extension regions ET3 and ET4 are each formed of at least a coloring material. Specifically, the extension regions ET3 and ET4 are each formed of a coloring material made of color ink ejected by the inkjet heads 10 to 13, or the coloring material made of the color ink ejected by the inkjet heads 10 to 13 and a transparent material made of a clear ink ejected by the inkjet head 14. In the present embodiment, the extension regions ET3 and ET4 are different from each other in texture. However, the extension regions ET3 and ET4 each may have the same texture.

The normal direction N3 of the present embodiment is a first normal direction, and the normal direction N4 is a second normal direction. The extension region ET3 of the present embodiment is a first extension region, and the extension region ET4 is a second extension region. FIGs. 5A and 5B are sectional views of the shaped object 2, corresponding to a section taken along line K-K of FIG. 6. The shaped object 2 is provided in its surface with a plane P3 (refer to FIGs. 5A and 5B) corresponding to the polygon PG3, and a plane P4 (refer to FIGs. 4A and 4B) corresponding to the polygon PG4.

As illustrated in FIG. 5A, when a region where the extension region ET3 and the extension region ET4 overlap with each other (specifically, a region where a part of the extension region ET3 and a part of the extension region ET4 overlap with each other) is indicated as a connection region CT5, a portion of the connection region CT5 on an extension region ET3 side is formed of a material identical to a material constituting the extension region ET3, and a residual portion of the connection region CT5 is formed of a material identical to a material constituting the extension region ET4, in the shaping method of the present embodiment. Specifically, as illustrated in FIG. 5A, a half portion CT6 of the connection region CT5 on the extension region ET3 side is formed of the material identical to the material constituting the extension region ET3, and a half portion CT7 of the connection region CT5 on the extension region ET4 side is formed of the material identical to the material constituting the extension region ET4.

Alternatively, a portion less than a half of the connection region CT5 on the extension region ET3 side may be formed of the material identical to the material constituting the extension region ET3, and a residual portion of the connection region CT5 may be formed of the material identical to the material constituting the extension region ET4. In addition, a portion more than a half of the connection region CT5 on the extension region ET3 side may be formed of the material identical to the material constituting the extension region ET3, and a residual portion of the connection region CT5 may be formed of the material identical to the material constituting the extension region ET4.

### (Main effect of the present embodiment)

As described above, in the shaping method of the present embodiment, the connection region CT1 between the extension region ET1 and the extension region ET2 in the colored region 2a is formed of the transparent material made of the clear ink ejected by the inkjet head 14, the white material made of the white ink ejected by the inkjet head 9, the material identical to the material constituting the end portion of the extension region ET1 on the connection region CT1 side, or the material identical to the material constituting the end portion of the extension region ET2 on the connection region CT1 side. Thus, shaping a shaped object 2 with the shaping method of the present embodiment enables an aesthetic appearance of the shaped object 2 to be maintained by preventing a surface of a portion provided with the recess 2c from being deformed and texture of the portion from being discontinuous even when the recess 2c is formed in a surface of the three-dimensional shaped object 2 having the colored region 2a with a predetermined thickness on the surface.

In the present embodiment, a portion of the connection region CT5 on the extension region ET3 side, where the extension region ET3 and the extension region ET4 overlap with each other, is formed of the material identical to the material constituting the extension region ET3, and a residual portion of the connection region CT5 is formed of the material identical to the material constituting the extension region ET4. Thus, shaping a shaped object 2 with the shaping method of the present embodiment enables an aesthetic appearance of the shaped object 2 to be maintained by preventing a surface of a portion provided with the protrusion 2d from being deformed and texture of the portion from being discontinuous even when the protrusion 2d is formed in a surface of the three-dimensional shaped object 2 having the colored region 2a with a predetermined thickness on the surface.

In the present embodiment, in particular, the half portion CT6 of the connection region CT5 on the extension region ET3 side is formed of the material identical to the material constituting the extension region ET3, and the half portion CT7 of the connection region CT5 on the extension region ET4 side is formed of the material identical to the material constituting the extension region ET4, so that texture of the portion provided with the protrusion 2d is less likely to be discontinuous according to the examination of the inventors of the present application. As a result, an aesthetic appearance of the shaped object 2 can be effectively maintained.

### (First modified example of shaping method)

In the embodiment described above, the portion of the connection region CT1 on the extension region ET1 side may be formed of the material identical to the material constituting the end portion of the extension region ET1 on the connection region CT1 side, and the residual portion of the connection region CT1 may be formed of the material identical to the material constituting the end portion of the extension region ET2 on the connection region CT1 side. For example, as illustrated in FIG. 4B, the half portion CT2 of the connection region CT1 on the extension region ET1 side may be formed of the material identical to the material constituting the end portion of the extension region ET1 on the connection region CT1 side, and the half portion CT3 of the connection region CT1 on the extension region ET2 side may be formed of the material identical to the material constituting the end portion of the extension region ET2 on the connection region CT1 side. Even this case enables obtaining a similar effect to that of the embodiment described above.

The portion less than a half of the connection region CT1 on the extension region ET1 side may be formed of the material identical to the material constituting the end portion of the extension region ET1 on the connection region CT1 side, and the residual portion of the connection region CT1 may be formed of the material identical to the material constituting the end portion of the extension region ET2 on the connection region CT1 side. In addition, the portion more than a half of the connection region CT1 on the extension region ET1 side may be formed of the material identical to the material constituting the end portion of the extension region ET1 on the connection region CT1 side, and the residual portion of the connection region CT1 may be formed of the material identical to the material constituting the end portion of the extension region ET2 on the connection region CT1 side.

In the embodiment described above, the connection region CT1 may be formed of a material containing the coloring material included in the end portion of the extension region ET1 on the connection region CT1 side and the coloring material included in the end portion of the extension region ET2 on the connection region CT1 side while the concentration of the material constituting the connection region CT1 may be reduced to less than the sum of the concentration of the material constituting the end portion of the extension region ET1 on the connection region CT1, and the concentration of the material constituting the end portion of the extension region ET2 on the connection region CT1. Even this case enables obtaining a similar effect to that of the embodiment described above. In this case, it is preferable to cause the concentration of the material constituting the connection region CT1 to be half of the sum of the concentration of the material constituting the end portion of the extension region ET1 on the connection region CT1 side and the concentration of the material constituting the end portion of the extension region ET2 on the connection region CT1 side.

Specifically, for example, in the following states: the end portion of the extension region ET1 on the connection region CT1 side is formed of a coloring material made of a color ink (cyan) ejected by the inkjet head 12 and a transparent material made of a clear ink ejected by the inkjet head 14 while the coloring material in the material constituting the end portion of the extension region ET1 on the connection region CT1 side and the transparent material therein each have a content ratio of 50%: and the end portion of the extension region ET2 on the connection region CT1 side is formed of a coloring material made of a color ink (magenta) ejected by the inkjet head 11 and the transparent material made of the clear ink ejected by the inkjet head 14, while the coloring material in the material constituting the end portion of the extension region ET2 on the connection region CT1 side and the transparent material therein each have a content ratio of 50%, it is preferable to allow the connection region CT1 to be formed of the coloring material made of the color ink ejected by the inkjet head 11, the coloring material made of the color ink ejected by the inkjet head 12, and the transparent material made of the clear ink ejected by the inkjet head 14 while the coloring material made of the color ink ejected by the inkjet head 11 in the material constituting the connection region CT1 and the coloring material made of the color ink ejected by the inkjet head 12 therein each have a content ratio of 25%, and the transparent material made of the clear ink ejected by the inkjet head 14 therein has a content ratio of 50%.

### (Second modified example of shaping method)

In the embodiment described above, the connection region CT5 may be formed of the material identical to the material constituting the extension region ET3 or the material identical to the material constituting the extension region ET4 (refer to FIG. 5B). Even this case enables obtaining a similar effect to that of the embodiment described above.

In the embodiment described above, the connection region CT5 may be formed of a material containing the coloring material included in the extension region ET3 and the coloring material included in the extension region ET4 while the concentration of the material constituting the connection region CT5 may be reduced to less than the sum of the concentration of the material constituting the extension region ET3, and the concentration of the material constituting the extension region ET4. Even this case enables obtaining a similar effect to that of the embodiment described above. In this case, it is preferable to cause the concentration of the material constituting the connection region CT5 to be half of the sum of the concentration of the material constituting the extension region ET3 and the concentration of the material constituting the extension region ET4.

Specifically, for example, in the following states: the extension region ET3 is formed of a coloring material made of a color ink (cyan) ejected by the inkjet head 12 and a transparent material made of a clear ink ejected by the inkjet head 14 while the coloring material in the material constituting the extension region ET3 and the transparent material therein each have a content ratio of 50%: and the extension region ET4 is formed of a coloring material made of a color ink (magenta) ejected by the inkjet head 11 and the transparent material made of the clear ink ejected by the inkjet head 14, while the coloring material in the material constituting the extension region ET4 and the transparent material therein each have a content ratio of 50%, it is preferable to allow the connection region CT5 to be formed of the coloring material made of the color ink ejected by the inkjet head 11, the coloring material made of the color ink ejected by the inkjet head 12, and the transparent material made of the clear ink ejected by the inkjet head 14 while the coloring material made of the color ink ejected by the inkjet head 11 in the material constituting the connection region CT5 and the coloring material made of the color ink ejected by the inkjet head 12 therein each have a content ratio of 25%, and the transparent material made of the clear ink ejected by the inkjet head 14 therein has a content ratio of 50%.

### (Other embodiments)

While the above-described embodiment is an example of a preferred embodiment of the present disclosure, the present disclosure is not limited thereto, and various modifications can be made without changing the essence of the present disclosure.

In the embodiment described above, the shaped object 2 may include a protecting region covering the colored region 2a. In this case, the protecting region is formed of a transparent material made of a clear ink ejected by the inkjet head 14, for example. In the embodiment described above, the shaped object 2 also may include a separation region disposed between the colored region 2a and the model region 2b. In this case, the separation region is formed of a transparent material made of a clear ink ejected by the inkjet head 14, for example.

In the embodiment described above, as illustrated in FIG. 8, the shaped object 2 may include a light reflecting region 2f that reflects light incident through the colored region 2a, separately from the model region 2b. The light reflecting region 2f is disposed between the colored region 2a and the model region 2b. That is, the light reflecting region 2f is disposed inward of the colored region 2a in the shaped object 2. The light reflecting region 2f is formed of a white material made of a white ink ejected by the inkjet head 9, for example. In this case, the model region 2b is formed of a material other than the white material, such as a coloring material or a transparent material, for example. In this case, the light reflecting region 2f has a constant thickness in the normal direction (direction perpendicular to the surface of the shaped object 2) at any place of the shaped object 2 to reduce color difference on the surface of the shaped object 2. In addition, a separation region may be provided between the colored region 2a and the light reflecting region 2f. It is preferable that the separation region also has a constant thickness at any place of the shaped object 2.

In the embodiment described above, the shaped object 2 may be shaped by ejecting a liquid of each of a binder in color of a subtractive color mixture, a transparent binder, a black binder, and a white binder to a structure of transparent resin powder or white resin powder with an inkjet method. In the embodiment described above, the polygons constituting the polygon model may be each a polygonal plane other than a triangular plane. For example, the polygon may be a quadrangular plane.

## Claims

1. A shaping method for shaping a three-dimensional shaped object, the shaped object including: a colored region that is at least partially colored; and a light reflecting region that is disposed inward of the colored region in the shaped object to reflect light incident through the colored region, in the following states: a plurality of polygons included in a polygon model being shape data on the shaped object include two polygons adjacent to each other, being connected to each other with a boundary line therebetween in a recessed manner on a surface side of the shaped object; one of the two polygons being indicated as a first polygon, and the other thereof being indicated as a second polygon; a direction of a normal of the first polygon, toward inside the shaped object, is indicated as a first normal direction, and a direction of a normal of the second polygon, toward inside the shaped object, is indicated as a second normal direction; a region of the shaped object corresponding to a region formed by translating a shape of the first polygon by a thickness of the colored region in the first normal direction in data is indicated as a first extension region, and a region of the shaped object corresponding to a region formed by translating a shape of the second polygon by the thickness of the colored region in the second normal direction in data is indicated as a second extension region, the shaping method comprising the steps of:
allowing the first and second extension regions to be included in the colored region and to be each formed of at least a coloring material; and
allowing a connection region between the first and second extension regions in the colored region to be formed of a transparent material, a material identical to a light reflecting material constituting the light reflecting region, a material identical to a material constituting an end portion of the first extension region on a connection region side, or of a material identical to a material constituting an end portion of the second extension region on a connection region side, or
allowing a portion of the connection region on a first extension region side to be formed of a material identical to a material constituting an end portion of the first extension region on a connection region side, and a residual portion of the connection region to be formed a material identical to a material constituting an end portion of the second extension region on a connection region side, or
allowing the connection region to be formed of a material containing the coloring material included in the end portion of the first extension region on the connection region side and the coloring material included in the end portion of the second extension region on the connection region side while reducing a concentration of the material constituting the connection region to less than a sum of a concentration of the material constituting the end portion of the first extension region on the connection region side and a concentration of the material constituting the end portion of the second extension region on the connection region side.

2. A shaping method for shaping a three-dimensional shaped object, the shaped object including: a colored region that is at least partially colored; and a light reflecting region that is disposed inward of the colored region in the shaped object to reflect light incident through the colored region, in the following states: a plurality of polygons included in a polygon model being shape data on the shaped object include two polygons adjacent to each other, being connected to each other with a boundary line therebetween in a protruding manner on a surface side of the shaped object; one of the two polygons is indicated as a first polygon, and the other thereof is indicated as a second polygon; a direction of a normal of the first polygon, toward inside the shaped object, is indicated as a first normal direction, and a direction of a normal of the second polygon, toward inside the shaped object, is indicated as a second normal direction; and a region of the shaped object corresponding to a region formed by translating a shape of the first polygon by a thickness of the colored region in the first normal direction in data is indicated as a first extension region, and a region of the shaped object corresponding to a region formed by translating a shape of the second polygon by the thickness of the colored region in the second normal direction in data is indicated as a second extension region, the shaping method comprising the steps of:
allowing the first and second extension regions to be included in the colored region and to be each formed of at least a coloring material; and
allowing a portion of a connection region where the first and second extension regions overlap with each other, on a first extension region side, to be formed of a material identical to a material constituting the first extension region, and a residual portion of the connection region to be formed of a material identical to a material constituting the second extension region, or
allowing the connection region to be formed of the material identical to the material constituting the first extension region or the material identical to the material constituting the second extension region, or
allowing the connection region to be formed of a material containing the coloring material included in the first extension region and the coloring material included in the second extension region while reducing a concentration of the material constituting the connection region to less than a sum of a concentration of the material constituting the first extension region and a concentration of the material constituting the second extension region.

3. The shaping method according to claim 2, wherein
a half portion of the connection region on the first extension region side is formed of the material identical to the material constituting the first extension region, and a half portion of the connection region on the second extension region side is formed of the material identical to the material constituting the second extension region.

4. The shaping method according to any one of claims 1 to 3, wherein
a colored portion in the colored region is formed of a coloring material, or formed of the coloring material and a transparent material.

5. The shaping method according to any one of claims 1 to 4, wherein
the light reflecting material constituting the light reflecting region is a white material.

6. The shaping method according to any one of claims 1 to 5, wherein
a portion inside the colored region of the shaped object is formed of a light reflecting material.

7. The shaping method according to any one of claims 1 to 6, wherein
when a direction perpendicular to a surface of the shaped object is indicated as a normal direction, the colored region has a constant thickness in the normal direction.

8. The shaping method according to any one of claims 1 to 7, wherein
when the direction perpendicular to the surface of the shaped object is indicated as the normal direction, the light reflecting region has a constant thickness in the normal direction.

9. The shaping method according to any one of claims 1 to 8, wherein
the shaped object is formed by an inkjet method.
